# EUROPEAN PATENT SPECIFICATION

(11) **EP 4 040 594 B1**
(45) Date of publication and mention of the grant of the patent: **25.02.2026**
(21) Application number: 20881880.7
(22) Date of filing: 19.10.2020
(51) Int. Cl.: H05K 7/20, H01Q 1/00, H01Q 1/32, H01Q 1/42, H01Q 1/02

(54) **VEHICLE-MOUNTED ANTENNA MODULE AND VEHICLE-MOUNTED COMMUNICATION TERMINAL**
FAHRZEUGMONTIERTES ANTENNENMODUL UND FAHRZEUGMONTIERTES KOMMUNIKATIONSENDGERÄT
MODULE D'ANTENNE MONTÉ SUR VÉHICULE ET TERMINAL DE COMMUNICATION MONTÉ SUR VÉHICULE

(30) Priority: 29.10.2019 CN 201911035837
(43) Date of publication of application: 10.08.2022
(73) Proprietor: Huawei Technologies Co., Ltd., Shenzhen, Guangdong 518129 (CN)
(72) Inventor: ZENG, Xiangfeng, Shenzhen, Guangdong 518129 (CN); LU, Weiqiang, Shenzhen, Guangdong 518129 (CN); XIE, Bo, Shenzhen, Guangdong 518129 (CN)
(74) Representative: Körber, Martin Hans
(86) International application number: PCT/CN2020/121838
(87) International publication number: WO 2021/082962

(56) References cited:
- CN-A- 104 144 589
- CN-A- 104 144 589
- CN-A- 105 990 273
- CN-A- 106 687 336
- CN-A- 106 921 581
- CN-A- 108 702 859
- CN-A- 110 808 443
- CN-U- 202 998 706
- CN-U- 207 053 986
- CN-U- 207 697 671
- CN-U- 208 085 593
- CN-U- 211 017 344
- DE-A1- 102010 064 343
- JP-A- 2017 152 810
- JP-B2- 5 920 123
- US-A1- 2014 062 808
- US-A1- 2016 024 358
- US-A1- 2017 170 542
- US-A1- 2019 312 342

## Description

### TECHNICAL FIELD

This application relates to the field of heat dissipation technologies of electronic elements, and in particular, to an in-vehicle antenna module that can reduce an operating temperature of a heat emitting element in a high-temperature environment.

### BACKGROUND

Development of mobile communication technologies, for example, a 5th generation mobile communication technology (5th generation mobile networks, 5G), promotes development of Internet of Vehicles (connected car) and automated driving technologies. A 5G antenna is mounted on an automobile, so that the automobile can access to a high-rate and low-latency 5G network. This implements Internet of Everything between automobiles and between the automobile and another communication device, and has a broad application prospect in improving vehicle driving experience, driving safety, and the like.

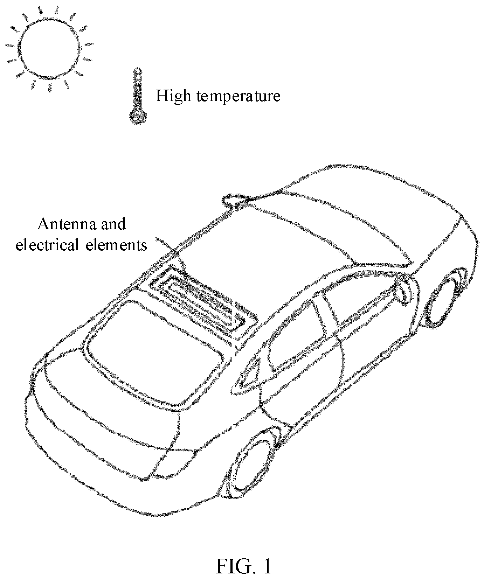

FIG. 1 is a schematic diagram of a structure of an automobile on which an antenna is mounted. As shown in FIG. 1, to improve communication quality between the automobile and the outside world, the antenna and electrical elements configured to process an antenna signal are usually mounted on a roof of the automobile. These electrical elements include a printed circuit board (printed circuit board, PCB) and a crystal module (including various chips and the like) that is mounted on the printed circuit board and that is configured to process the antenna signal. Because the automobile is mostly driven and parked outdoors, the roof is directly exposed to outdoor sunlight and has a high temperature. When the temperature of the roof increases, an abnormal phenomenon occurs on the crystal module mounted on the roof, for example, frequency reduction caused by overheating. If the temperature of the roof reaches a threshold temperature of the crystal module (for example, a threshold temperature of a semiconductor chip is usually 105°C), the crystal module performs overheating self-protection, or is even damaged. Therefore, to stably operate, the crystal module mounted on the roof needs to effectively dissipate heat.

Currently, an air-cooled heat dissipation manner is mainly used for heat dissipation for a heat emitting element, for example, the crystal module. To be specific, a fan is mounted on the heat emitting element, and the fan is used to accelerate air flow near the heat emitting element and take away heat generated by the heat emitting element to implement heat dissipation. The air-cooled heat dissipation manner cannot make a temperature of the heat emitting element lower than an ambient temperature, and the heat emitting element has a higher temperature if the ambient temperature is higher. Consequently, a heat dissipation effect of the air-cooled heat dissipation manner is poorer. Therefore, air-cooled heat dissipation cannot meet a heat dissipation requirement of the heat emitting element when the temperature of the roof reaches or approaches a threshold temperature of the heat emitting element.
Related prior art in e. g. disclosed in JP 2017-152810 A and US 2019/312342 A1.

### SUMMARY

This application provides an in-vehicle antenna module and an in-vehicle communication terminal, to reduce an operating temperature of a heat emitting element in a high-temperature environment.

According to a first aspect, this application provides an in-vehicle antenna module. The in-vehicle antenna module includes an antenna housing, a printed circuit board module, a heat exchange module, a uniform temperature metal plate, and a heat sink. The heat exchange module includes a cold side and a hot side, where a temperature of the cold side is lower than a temperature of the hot side, and the heat exchange module is configured to conduct heat from the cold side to the hot side. The printed circuit board module includes a printed circuit board, and an antenna and a crystal module that are mounted on the printed circuit board, and the printed circuit board module is attached to the cold side. The uniform temperature metal plate is attached to the hot side. The heat sink is attached to one side that is of the uniform temperature metal plate and that faces away from the heat exchange module. The antenna housing is disposed on one side that is of the uniform temperature metal plate and that faces the heat exchange module, fastening structures that cooperate with each other are respectively disposed on the uniform temperature metal plate and the antenna housing, and the uniform temperature metal plate and the antenna housing are fixedly connected through the fastening structures, to enclose the printed circuit board module and the heat exchange module in the antenna housing.

According to the technical solution provided in this application, based on a characteristic that the heat exchange module can conduct the heat from the cold side to the hot side, the cold side is attached to the printed circuit board module, and the hot side is attached to the uniform temperature metal plate, so that the heat exchange module can absorb, on the cold side, heat generated by the crystal module and the like on the printed circuit board module, to cool the printed circuit board module, and can transfer, on the hot side, the absorbed heat to the uniform temperature metal plate, to dissipate the heat to an environment by using the uniform temperature metal plate and the heat sink. Therefore, an operating temperature of a heat emitting element, for example, the crystal module, in a high-temperature environment can be reduced according to the technical solution provided in this application, so that a temperature of the heat emitting element can be lower than an ambient temperature, and even if the ambient temperature increases to a threshold temperature of the heat emitting element, the heat emitting element can also stably operate.

Optionally, the crystal module is disposed on one side that is of the printed circuit board and that faces the heat exchange module; and the crystal module is attached to the cold side. Therefore, the heat exchange module can be directly attached to the crystal module, so that the heat exchange module can directly cool the crystal module.

Optionally, the printed circuit board is attached to the cold side; and the crystal module is disposed on one side that is of the printed circuit board and that faces away from the heat exchange module. Therefore, the heat exchange module can be attached to the printed circuit board, so that a heat exchange channel is established between the crystal module and the heat exchange module through the printed circuit board, and the heat exchange module can indirectly cool the crystal module and another heat emitting element in a manner of cooling the printed circuit board.

Optionally, the uniform temperature metal plate is recessed in a direction away from the heat exchange module, to form a first groove; the heat exchange module is disposed in the first groove, and the hot side is attached to a bottom of the first groove; the heat sink is recessed in a direction away from the uniform temperature metal plate, to form a second groove that matches the first groove in shape; and the first groove is embedded into the second groove, and the first groove is tightly attached to the second groove. Therefore, the first groove and the second groove enable the heat exchange module, the uniform temperature metal plate, and the heat sink to be mutually nested and connected, thereby increasing a contact area among the heat exchange module, the uniform temperature metal plate, and the heat sink, and improving heat transfer efficiency among the heat exchange module, the uniform temperature metal plate, and the heat sink.

Optionally, a thermally conductive medium is disposed between the heat exchange module and the crystal module, and the cold side is attached to the crystal module through the thermally conductive medium. The thermally conductive medium can fill a slit between the heat exchange module and the crystal module, to improve heat transfer efficiency between the cold side and the crystal module.

Optionally, the antenna is disposed on one side that is of the printed circuit board and that faces away from the heat exchange module. Therefore, the antenna is directly exposed under the antenna housing, and there is no other obstacle between the antenna and the antenna housing, so that a signal strength during communication between the antenna and an external device is not affected.

Optionally, the heat exchange module is a thermoelectric cooler (thermoelectric cooler, TEC). Therefore, a Peltier effect of the thermoelectric cooler is used. A cold side and a hot side of the thermoelectric cooler can be formed by energizing the thermoelectric cooler according to the Peltier effect, where a temperature of the cold side can be much lower than the ambient temperature. Therefore, the cold side is used to cool the heat emitting element. This can greatly reduce the temperature of the heat emitting element.

Optionally, the thermoelectric cooler includes a plurality of thermocouple pairs, and each thermocouple pair is formed by connecting an N-type semiconductor and a P-type semiconductor; the plurality of thermocouple pairs are arranged between two ceramic electrodes; and the thermocouple pairs are configured to transfer heat from the cold side to the hot side when a current passes through.

Optionally, a fin structure is disposed on one side that is of the heat sink and that faces away from the uniform temperature metal plate; the fin structure includes a plurality of fins, and the fins extend in a direction away from the uniform temperature metal plate; and the plurality of fins are spaced from each other in parallel. The fin structure can increase a heat dissipation area of the heat sink, and improve heat dissipation efficiency of the heat sink.

According to a second aspect, this application provides a vehicle. The vehicle includes the in-vehicle antenna module provided in the first aspect. A chamber configured to accommodate the in-vehicle antenna module is disposed on a roof housing of the vehicle, and the in-vehicle antenna module is disposed in the chamber. An antenna cover is further disposed on the roof housing, and the antenna cover is buckled on the chamber to enclose the chamber, so that the in-vehicle antenna module is hidden inside the roof housing, thereby preventing a roof appearance from being affected.

### BRIEF DESCRIPTION OF DRAWINGS

FIG. 1 is a schematic diagram of a structure of an automobile on which an antenna is mounted;
FIG. 2 is a schematic diagram of a structure of a current air-cooled heat dissipation solution;
FIG. 3 is an exploded diagram of a structure of a heat dissipation apparatus according to a first embodiment of this application;
FIG. 4 is a schematic diagram of a structure of a uniform temperature metal plate according to a first embodiment of this application;
FIG. 5 is a schematic diagram of a structure of a heat sink according to a first embodiment of this application;
FIG. 6 is a schematic diagram of a structure of a heat exchange module according to a first embodiment of this application;
FIG. 7 is a cross-sectional view of a heat dissipation apparatus according to a first embodiment of this application in a direction B;
FIG. 8 is a schematic diagram of a structure in which a heat dissipation apparatus is used in a printed circuit board module to implement heat dissipation;
FIG. 9 is a schematic diagram of another structure in which a heat dissipation apparatus is used in a printed circuit board module to implement heat dissipation;
FIG. 10 is a schematic diagram of a structure of an in-vehicle antenna module according to a fourth embodiment of this application;
FIG. 11 is a cross-sectional view of an in-vehicle antenna module according to a fourth embodiment of this application in a direction B;
FIG. 12 is a schematic diagram of mounting an in-vehicle antenna module on a roof according to a fourth embodiment of this application;
FIG. 13 is a schematic diagram of communication between an in-vehicle communication terminal and a mobile device;
FIG. 14 is a schematic diagram of a structure of an in-vehicle communication terminal according to a fifth embodiment of this application, not part of the invention defined by the appended claims; and
FIG. 15 is a flowchart of a temperature control method according to a sixth embodiment of this application.

### Illustration:

011-heat sink, 012-fan, 100-heat exchange module, 200-uniform temperature metal plate, 210-first groove, 220-fastening structure, 300-heat sink, 310-fin structure, 311-fin, 320-second groove, 400-heat emitting element, 500-printed circuit board module, 510-printed circuit board, 520-antenna, 530-crystal module, 600-antenna housing, 610-fastening structure, 700-thermally conductive medium, 800-terminal housing, 810-opening, 910-roof housing, 920-interior decoration, 930-in-vehicle antenna module, 940-chamber, 950-antenna cover, 960-in-vehicle communication terminal, 970-external antenna, and 980-mobile device.

### DESCRIPTION OF EMBODIMENTS

The following clearly describes technical solutions in embodiments of this application with reference to the accompanying drawings in the embodiments of this application. It is clear that the described embodiments are merely some but not all of the embodiments of this application. All other embodiments obtained by a person of ordinary skill in the art based on the embodiments of this application without creative efforts shall fall within the protection scope of this application.

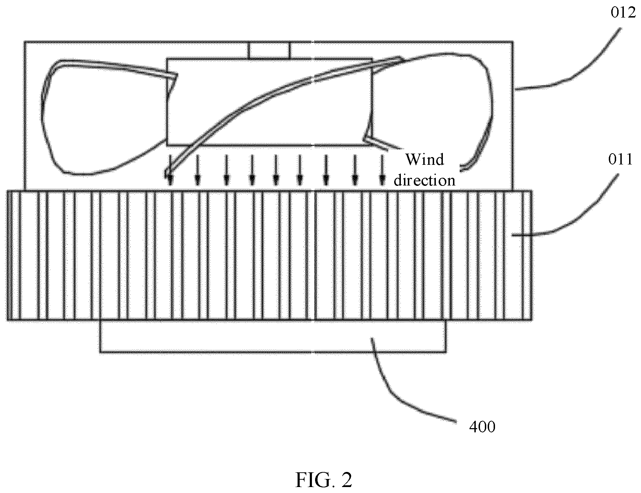

FIG. 2 is a schematic diagram of a structure of a current air-cooled heat dissipation solution.

As shown in FIG. 1, the current air-cooled heat dissipation solution includes a heat sink 011 and a fan 012. The heat sink 011 is attached to a heat emitting element 400, and is configured to absorb heat generated by the heat emitting element 400. The fan 012 is disposed on the heat sink 011, and blows towards the heat sink 011, to accelerate air flow near the heat emitting element 400 and take away the heat generated by the heat emitting element 400 to implement heat dissipation. The air-cooled heat dissipation manner cannot make a temperature of the heat emitting element 400 lower than an ambient temperature, and the heat emitting element 400 has a higher temperature under a higher ambient temperature. Consequently, a heat dissipation effect of the air-cooled heat dissipation manner is poorer. When the ambient temperature reaches or approaches a threshold temperature of the heat emitting element 400, a heat dissipation requirement of the heat emitting element 400 cannot be met according to the air-cooled heat dissipation manner. In addition, the fan 012 generates noise during operation. If the fan 012 is disposed on a roof, ride experience of a passenger in a vehicle is further affected. In addition, air needs to have good fluidity in the air-cooled heat dissipation manner. However, a space in the roof is enclosed. This cannot meet a fluidity requirement of the air-cooled heat dissipation manner for air. In addition, the space in the roof is flat. To place the fan 012 on the roof, a thickness of the roof needs to be increased. This affects an appearance of the entire vehicle.

To resolve the foregoing problems, this application provides a heat dissipation apparatus, and an in-vehicle antenna module that includes the heat dissipation apparatus, to reduce the temperature of the heat emitting element 400 (for example, a crystal module such as a chip) to be lower than the ambient temperature.

The following is a first embodiment of this application.

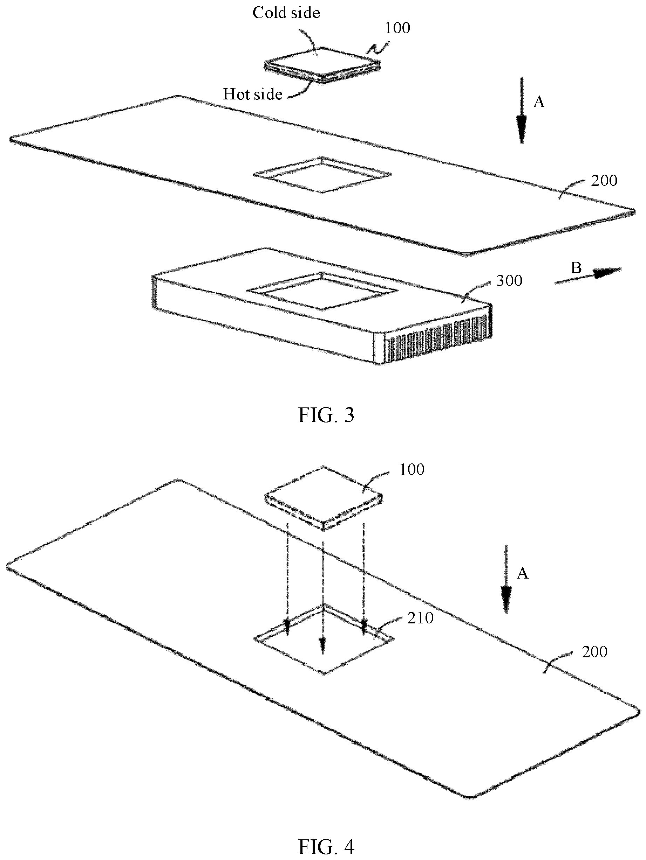

The first embodiment of this application provides a heat dissipation apparatus. FIG. 3 is an exploded diagram of a structure of the heat dissipation apparatus according to the first embodiment of this application. As shown in FIG. 3, the heat dissipation apparatus includes a heat exchange module 100, a uniform temperature metal plate 200, and a heat sink 300. The heat exchange module 100, the uniform temperature metal plate 200, and the heat sink 300 are stacked in a direction A in FIG. 3, and the uniform temperature metal plate 200 is located between the heat exchange module 100 and the heat sink 300.

The heat exchange module 100 includes a cold side and a hot side. The cold side and the hot side are opposite in direction. The heat exchange module 100 can conduct heat from the cold side to the hot side under external action (for example, a voltage, a current, a pressure, and light) or spontaneously, so that the cold side has a temperature lower than an ambient temperature. The hot side of the heat exchange module 100 is attached to one side of the uniform temperature metal plate 200, and corresponding to the heat exchange module 100, the heat sink 300 is attached to the other side of the uniform temperature metal plate 200. A thermally conductive medium, for example, thermally conductive silicone or a thermally conductive pad, may be filled between the heat exchange module 100 and the uniform temperature metal plate 200, to fill a slit that may exist after the heat exchange module 100 is attached to the uniform temperature metal plate 200. This is conducive to transferring heat between the heat exchange module 100 and the uniform temperature metal plate 200. The thermally conductive medium may be also filled between the uniform temperature metal plate 200 and the heat sink 300, to fill a slit that may exist after the uniform temperature metal plate 200 is attached to the heat sink 300. This is conducive to transferring heat between the uniform temperature metal plate 200 and the heat sink 300. In this way, a heat transfer path from the heat exchange module 100 to the uniform temperature metal plate 200 to the heat sink 300 is continuous, thereby implementing high heat transfer efficiency.

FIG. 4 is a schematic diagram of a structure of the uniform temperature metal plate 200 according to the first embodiment of this application. As shown in FIG. 4, the uniform temperature metal plate 200 is recessed in a direction A away from the heat exchange module 100 to form a first groove 210, and a size of the first groove 210 is greater than or equal to a size of the heat exchange module 100, so that the heat exchange module 100 can be disposed in the first groove 210. The uniform temperature metal plate 200 may be made of a material having excellent thermal conductivity, for example, copper or aluminum. A size of the uniform temperature metal plate 200 is greater than the size of the heat exchange module 100, so that the uniform temperature metal plate 200 can completely cover the heat exchange module 100, have a larger contact area with the heat exchange module 100, fully absorb heat from the heat exchange module 100, and improve heat dissipation performance of the heat exchange module 100.

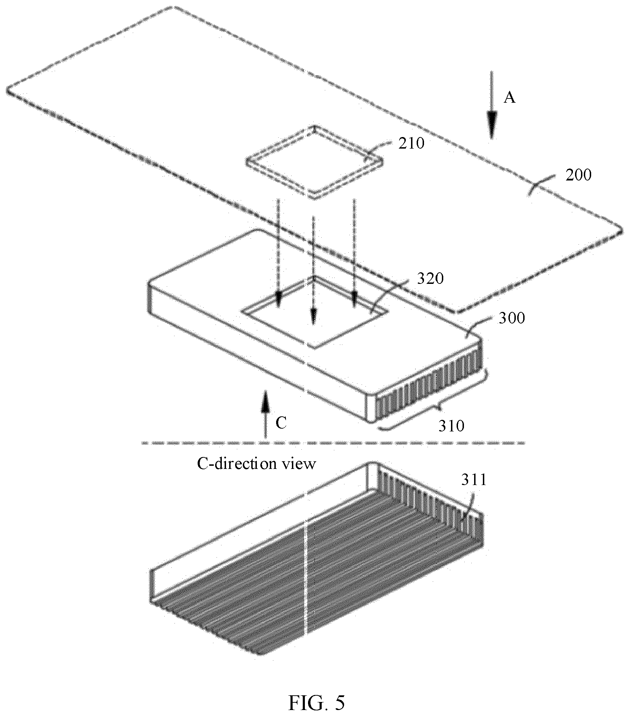

FIG. 5 is a schematic diagram of a structure of the heat sink 300 according to the first embodiment of this application. As shown in FIG. 5, one side that is of the heat sink 300 and that faces the uniform temperature metal plate 200 is hollowed out to form a second groove 320 that matches the first groove 210 in shape. The first groove 210 of the uniform temperature metal plate 200 may be embedded into the second groove 320 of the heat sink 300, so that the first groove 210 is in close contact with the second groove 320, a contact area between the uniform temperature metal plate 200 and the heat sink 300 is increased, and heat transfer efficiency between the uniform temperature metal plate 200 and the heat sink 300 is improved. A fin structure 310 is disposed on one side that is of the heat sink 300 and that faces away from the uniform temperature metal plate 200, the fin structure includes a plurality of fins 311 spaced from each other in parallel, and the fins extend in a direction away from the uniform temperature metal plate. The fin structure 310 can increase a surface area of the heat sink 300, thereby improving heat dissipation performance of the heat sink 300.

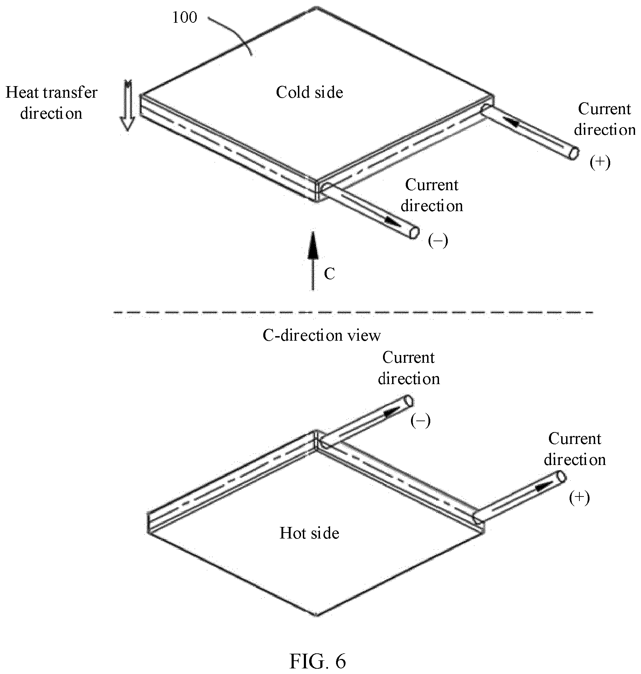

FIG. 6 is a schematic diagram of a structure of the heat exchange module 100 according to the first embodiment of this application. As shown in FIG. 6, the heat exchange module 100 may be a thermoelectric cooler (thermoelectric cooler, TEC), and the thermoelectric cooler is a cooling apparatus manufactured by using a Peltier effect of a semiconductor. The so-called Peltier effect means that when a current passes through a galvanic couple including two semiconductor materials, heat transfer occurs between two ends of the galvanic couple, that is, heat is transferred from one end to the other end, to form a phenomenon in which one end absorbs heat and the other end dissipates heat. An N-type semiconductor and a P-type semiconductor obtained based on bismuth telluride heavily doped with impurities are main materials for manufacturing the thermoelectric cooler. The bismuth telluride elements are electrically connected in series and generate heat in parallel. The thermoelectric cooler includes a plurality of thermocouple pairs (groups) formed by connecting N-type semiconductors and P-type semiconductors, the plurality of thermocouple pairs are connected together through electrodes, and are disposed between two ceramic electrodes. When a current passes through the thermoelectric cooler, the thermocouple pairs transfer heat from one side of the thermoelectric cooler to the other side of the thermoelectric cooler, so that the thermoelectric cooler has a hot side (one side on which heat comes in) and a cold side (one side on which heat comes out), where a temperature of the cold side may be much lower than the ambient temperature.

It should be further noted herein that in addition to being a thermoelectric cooler, the heat exchange module 100 in this application may be alternatively another cooler. The cooler may include a hot side and a cold side as the thermoelectric cooler shown in FIG. 6, and heat in the cooler can be conducted from the cold side to the hot side under external action (for example, a voltage, a current, and a pressure) or spontaneously, so that the cold side has a low temperature.

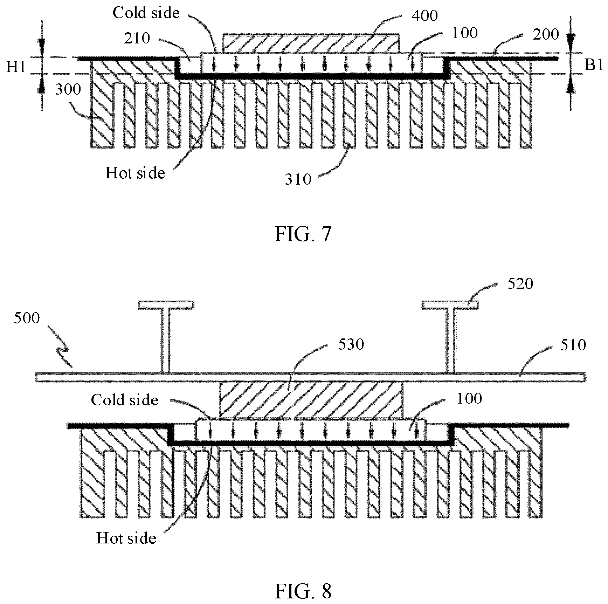

FIG. 7 is a cross-sectional view of the heat dissipation apparatus according to the first embodiment of this application in a direction B. As shown in FIG. 7, the heat sink 300 and the uniform temperature metal plate 200 form a tight embedded connection by using respective groove structures. The heat exchange module 100 is disposed in the first groove 210 of the uniform temperature metal plate 200, the hot side of the heat exchange module 100 faces the first groove 210, and the hot side of the heat exchange module 100 is in contact with a bottom of the first groove 210. A depth H1 of the first groove 210 in a direction A may be less than or equal to a thickness B1 of the heat exchange module 100 in the direction A. In this way, when the heat exchange module 100 is disposed in the first groove 210, the cold side of the heat exchange module 100 is higher than the uniform temperature metal plate 200, so that the cold side of the heat exchange module 100 can contact the heat emitting element 400. The depth H1 of the first groove 210 in the direction A may be alternatively greater than the thickness B1 of the heat exchange module 100 in the direction A. In this way, when the heat exchange module 100 is disposed in the first groove 210, the cold side of the heat exchange module 100 is lower than the uniform temperature metal plate 200, and the heat emitting element 400 may be partially disposed in the first groove 210 to be in contact with the heat exchange module 100, thereby reducing a total thickness obtained after the heat dissipation apparatus contacts the heat emitting element 400.

The heat emitting element 400 in this application includes but is not limited to a printed circuit board (printed circuit board, PCB), a crystal module (including various chips such as a system-on-a-chip (system on a chip, SOC), a front-end radio frequency chip, and a modem chip), and another electronic element that can generate heat during operation.

The following specifically describes, with reference to FIG. 7, an operation principle of the heat dissipation apparatus provided in the first embodiment of this application. As shown in FIG. 7, the heat emitting element 400 is attached to the cold side of the heat exchange module 100. When operating, the heat exchange module 100 can conduct heat from the cold side to the hot side, so that the cold side has a temperature lower than the ambient temperature. Therefore, the heat exchange module 100 can cool the heat emitting element 400 on the cold side, so that the temperature of the heat emitting element 400 greatly decreases, and is lower than the ambient temperature, and a component can stably operate at a high ambient temperature. Heat on the hot side of the heat exchange module 100 can be diffused to the uniform temperature metal plate 200, and further diffused to the heat sink 300 through the uniform temperature metal plate 200. Because of having the fin structure 310, the heat sink 300 can have a larger contact area with an environment and efficiently diffuse heat into the environment.

The technical solution provided in the first embodiment of this application has the following beneficial effects: In the heat dissipation apparatus provided in the first embodiment of this application, a cooling and heat transfer channel from a component to an external environment is formed, and the temperature of the heat emitting element 400 can be reduced to be lower than the ambient temperature. Even if the ambient temperature is higher than the threshold temperature at which the heat emitting element 400 normally operates, the temperature of the heat emitting element 400 can be reduced to be lower than the threshold temperature, and overheating protection, frequency reduction (when the heat emitting element 400 is a semiconductor chip), and damage do not occur, so that the heat emitting element 400 can stably operate in the high ambient temperature.

The following is a second embodiment of this application.

The second embodiment of this application provides an embodiment in which the heat dissipation apparatus is used in a printed circuit board module 500 to implement heat dissipation. FIG. 8 is a schematic diagram of a structure in which the heat dissipation apparatus is used in the printed circuit board module 500 to implement heat dissipation. As shown in FIG. 8, the printed circuit board module 500 includes a printed circuit board 510 and various components mounted on the printed circuit board 510. For example, when the printed circuit board module 500 is a smart in-vehicle antenna system, the components mounted on the printed circuit board 510 may include an antenna 520 and a crystal module 530 (including various chips and the like) configured to process an antenna signal.

In the second embodiment of this application, the cold side of the heat exchange module 100 is attached to a surface of the crystal module 530 to directly cool the crystal module 530, so that a temperature of the crystal module 530 is always lower than the ambient temperature. Therefore, even if the ambient temperature is higher than the threshold temperature at which the heat emitting element 400 normally operates, the temperature of the crystal module 530 can be reduced to be lower than the threshold temperature, and overheating protection, frequency reduction, and damage do not occur, so that the crystal module 530 can stably operate.

The following is a third embodiment of this application.

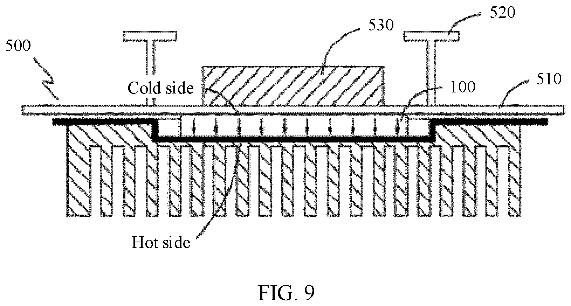

The third embodiment of this application provides another implementation in which the heat dissipation apparatus is used in a printed circuit board module 500. FIG. 9 is a schematic diagram of another structure in which the heat dissipation apparatus is used in the printed circuit board module 500 to implement heat dissipation. As shown in FIG. 9, the printed circuit board module 500 includes a printed circuit board 510 and various components mounted on the printed circuit board 510. For example, when the printed circuit board module 500 is a smart in-vehicle antenna module, the components mounted on the printed circuit board 510 may include an antenna 520 and a crystal module 530 (including various chips and the like) configured to process an antenna signal.

In the third embodiment of this application, the cold side of the heat exchange module 100 is directly attached to the printed circuit board 510, to directly cool the printed circuit board 510, and reduce an overall temperature of the printed circuit board 510, so that a local temperature of the printed circuit board 510 is lower than the ambient temperature. When the crystal module 530 mounted on the printed circuit board 510 generates heat, a larger temperature difference is generated between the crystal module 530 and the printed circuit board 510, so that heat of the crystal module 530 is rapidly conducted to the printed circuit board 510. This helps reduce a temperature of the crystal module 530.

It should be further noted that the cold side of the heat exchange module 100 may be attached to a position that is of the printed circuit board 510 and that corresponds to the crystal module 530 with a high heating capacity, so that a heat exchange channel with a shortest length is established between the crystal module 530 and the heat exchange module 100 through the printed circuit board 510. This is conducive to reducing the temperature of the crystal module 530 to be lower than the ambient temperature. Therefore, even if the ambient temperature is higher than the threshold temperature at which the heat emitting element 400 normally operates, the temperature of the crystal module 530 can be reduced to be lower than the threshold temperature, and overheating protection, frequency reduction, and damage do not occur, so that the crystal module 530 can stably operate.

The following is a fourth embodiment of this application.

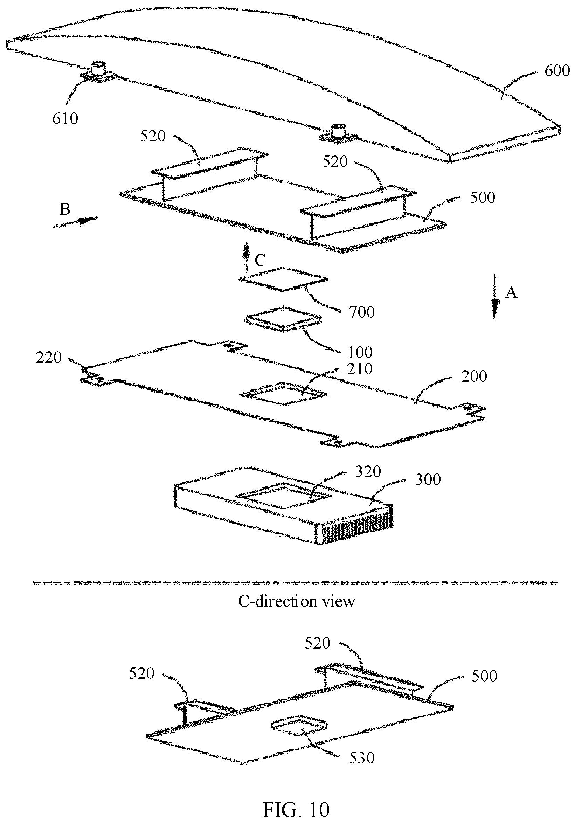

The fourth embodiment of this application provides an in-vehicle antenna module. The in-vehicle antenna module includes the heat dissipation apparatus in the foregoing embodiments of this application. FIG. 10 is a schematic diagram of a structure of the in-vehicle antenna module according to the fourth embodiment of this application. As shown in FIG. 10, the in-vehicle antenna module includes an antenna housing 600, a printed circuit board module 500, a thermally conductive medium 700. a heat exchange module 100, a uniform temperature metal plate 200, and a heat sink 300. The heat exchange module 100, the uniform temperature metal plate 200, and the heat sink 300 are stacked, the heat exchange module 100 is disposed on one side of the uniform temperature metal plate 200, the heat sink 300 is disposed on the other side of the uniform temperature metal plate 200, and the uniform temperature metal plate 200 is located between the heat exchange module 100 and the heat sink 300. A hot side of the heat exchange module 100 faces the uniform temperature metal plate, the uniform temperature metal plate 200 is recessed in a direction away from the heat exchange module 100 to form a first groove 210, and a size of the first groove 210 is greater than or equal to a size of the heat exchange module 100. The heat exchange module 100 is disposed in the first groove 210, and the hot side of the heat exchange module is attached to a bottom of the first groove 210. The uniform temperature metal plate 200 may be made of a material having excellent thermal conductivity, for example, copper or aluminum. A size of the uniform temperature metal plate 200 is greater than the size of the heat exchange module 100, so that the uniform temperature metal plate 200 can completely cover the heat exchange module 100, fully absorb heat from the heat exchange module 100, and improve heat dissipation performance of the heat exchange module 100. One side that is of the heat sink 300 and that faces the uniform temperature metal plate 200 is recessed in a direction away from the uniform temperature metal plate 200 to form a second groove 320 that matches the first groove 210 in shape. The first groove 210 of the uniform temperature metal plate 200 may be embedded into the second groove 320 of the heat sink 300, so that the first groove 210 is tightly attached to the second groove 320, a contact area between the uniform temperature metal plate 200 and the heat sink 300 is increased, and heat transfer efficiency between the uniform temperature metal plate 200 and the heat sink 300 is improved. The printed circuit board module 500 faces a cold side of the heat exchange module 100, and the printed circuit board module 500 includes a printed circuit board 510, an antenna 520, and a crystal module 530. The antenna 520 is disposed on one side that is of the printed circuit board 510 and that faces away from the heat exchange module 100. The crystal module 530 is disposed on one side that is of the printed circuit board 510 and that faces the heat exchange module 100, and the crystal module 530 is attached to the cold side of the heat exchange module 100. A fastening structure 220 and a fastening structure 610 that cooperate with each other are respectively disposed on the uniform temperature metal plate 200 and the antenna housing 600, the antenna housing 600 is buckled on the uniform temperature metal plate 200 in a direction (namely, the direction A in FIG. 9) from the printed circuit board module 500 to the heat sink 300, and is fixedly connected to the uniform temperature metal plate 200 through the fastening structure 220 and the fastening structure 610, to enclose the printed circuit board module 500 and the heat exchange module 100 in the antenna housing 600, so that the printed circuit board module 500 and the heat exchange module 100 are isolated from an external environment, thereby preventing the printed circuit board module 500 and the heat exchange module 100 from being immersed in water or affected by sunlight, dust, and the like. The in-vehicle antenna module provided in this embodiment of this application may be mounted on a body part of an automobile, for example, a roof of the automobile, so that the automobile has a capability of performing wireless communication with another network device.

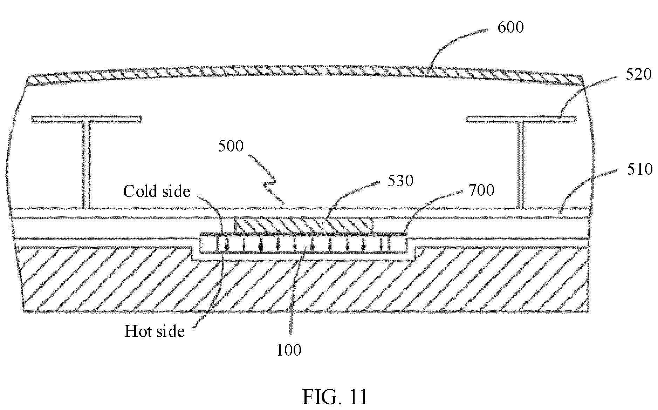

FIG. 11 is a cross-sectional view of the in-vehicle antenna module according to the fourth embodiment of this application in a direction B. As shown in FIG. 11, the antenna housing 600 has an arc-shaped structure that matches the roof in radian. The antenna 520 is disposed on one side that is of the printed circuit board 510 and that faces the antenna housing 600. The crystal module 530 is disposed on one side that is of the printed circuit board 510 and that faces the uniform temperature metal plate. The crystal module 530 is attached to the cold side of the heat exchange module 100 through the thermally conductive medium 700. The uniform temperature metal plate 200 is attached to the hot side of the heat exchange module 100.

In this embodiment of this application, the antenna housing 600 may be made of a non-metal material, for example, plastic or fiber, so that an electromagnetic wave signal can penetrate through the antenna housing 600 to be received by the antenna 520, and an electromagnetic wave signal sent by the antenna 520 can also penetrate through the antenna housing 600 to be received by another device. The antenna housing 600 may be alternatively made of a metal material, and a slit is formed by removing a material. A non-metal material, for example, plastic, is used to fill the slit, to form a micro-slit antenna 520 structure.

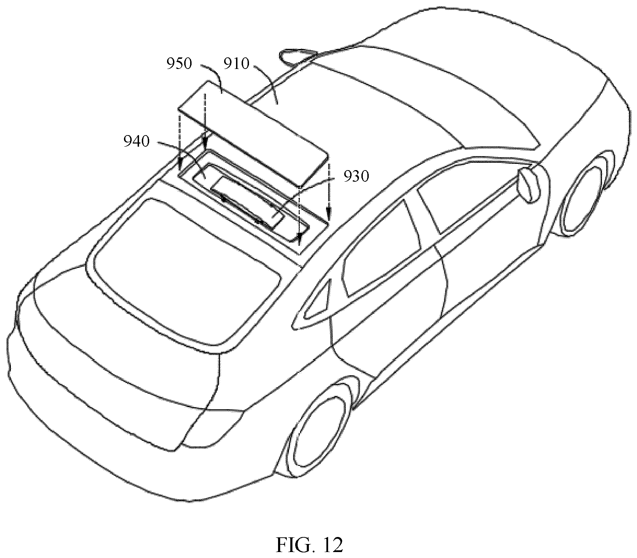

FIG. 12 is a schematic diagram of mounting the in-vehicle antenna module on the roof according to the fourth embodiment of this application. As shown in FIG. 12, a chamber 940 configured to accommodate the in-vehicle antenna module 930 is disposed on a roof housing 910 of the automobile, and the in-vehicle antenna module 930 is disposed in the chamber 940. An antenna cover 950 is further disposed on the roof housing 910, and the antenna cover 950 is buckled on the chamber 940 to enclose the chamber 940, so that the in-vehicle antenna module 930 is hidden inside the roof housing 910, thereby preventing a roof appearance from being affected.

The following specifically describes, with reference to FIG. 11, a beneficial effect that can be implemented by the in-vehicle antenna module provided in the fourth embodiment of this application. The in-vehicle antenna module may be usually disposed on a housing of the automobile, for example, the roof. Because the automobile is mostly driven and parked outdoors, the roof is often exposed to sunlight, and has an extremely high temperature. A high-temperature environment of the roof poses a challenge to normal operation of a smart in-vehicle module. When heat of the high-temperature environment is superimposed with heat generated when the crystal module 530 operates, a temperature of the crystal module 530 may be close to or even higher than a threshold temperature (for example, a threshold temperature of a semiconductor chip is about 105°C). This leads to frequency reduction caused by overheating, power-off self-protection, or even damage to the crystal module 530. A conventional in-vehicle antenna module uses a fan for heat dissipation, to be specific, air flow near the crystal module 530 is accelerated by the fan, and heat is taken away, to cool the crystal module 530. Because fan heat dissipation cannot make the temperature of the crystal module 530 to be lower than an ambient temperature, in the high-temperature environment, the fan heat dissipation has a poor cooling effect on the crystal module 530, and there is still a risk that the temperature of the crystal module 530 is excessively high. The in-vehicle antenna module provided in the fourth embodiment of this application implements heat dissipation by using the heat dissipation apparatus provided in any one of the foregoing embodiments, so that the temperature of the crystal module 530 can be reduced to be lower than the ambient temperature. Even if the roof is exposed to sunlight and has the extremely high temperature, the temperature of the crystal module 530 does not approach the threshold temperature, so that the crystal module 530 can continuously stably operate without frequency reduction, self-protection, or damage. In addition, the in-vehicle antenna module provided in the fourth embodiment of this application has no fan, so that noise is not generated; and there is no need to add an air duct to the roof, so that a structure is compact, a roof thickness is not increased, an appearance of the entire vehicle is not affected, and user experience is improved.

The following is a fifth embodiment, which does not form part of the invention but represents background art that is useful for understanding the invention.

The fifth embodiment of this application provides an in-vehicle communication terminal. The in-vehicle communication terminal part includes the heat dissipation apparatus in the foregoing embodiments of this application. The in-vehicle communication terminal is also referred to as an in-vehicle T-BOX (Telematics BOX), and is one of four major components of an Internet of Vehicles system (the Internet of Vehicles system includes a host, the in-vehicle T-BOX, a mobile device APP, and a background system). The in-vehicle communication terminal is mainly configured to communicate with the background system/a mobile device, to display and control vehicle information of the mobile device APP. The mobile device may be, for example, a mobile phone, a tablet computer, or a wearable smart device.

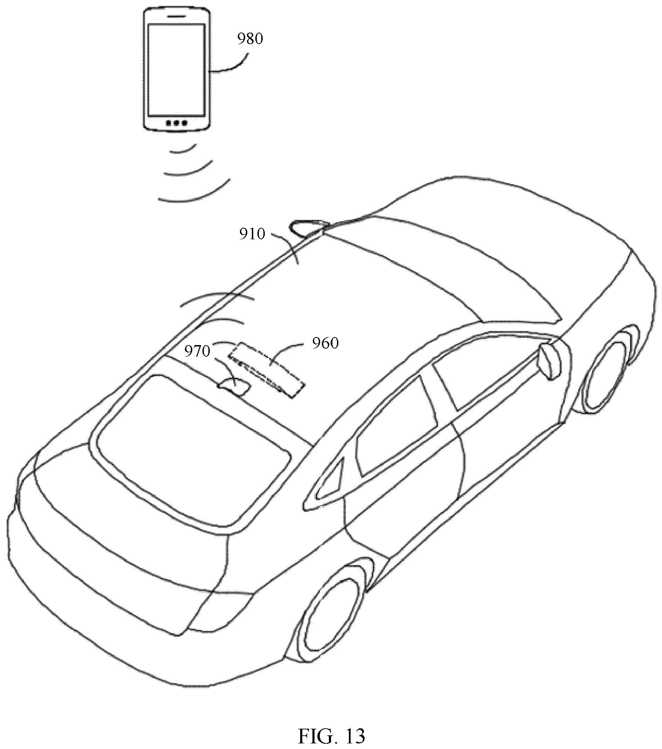

FIG. 13 is a schematic diagram of communication between the in-vehicle communication terminal and the mobile device. As shown in FIG. 13, the in-vehicle communication terminal 960 is hidden on an inner side of a roof housing 910 of an automobile, the in-vehicle communication terminal 960 is connected to an external antenna 970 of the automobile through a cable or the like, and the external antenna may be a shark fin antenna at a rear part of a roof. A communication connection is established between the in-vehicle communication terminal 960 and the mobile device 980 through the external antenna 970, to display and control the vehicle information of the mobile device APP.

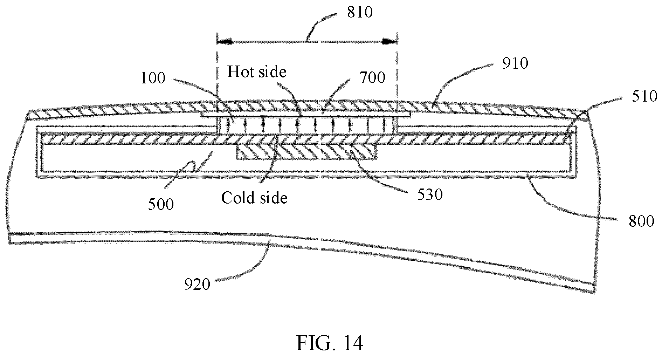

FIG. 14 is a schematic diagram of a structure of the in-vehicle communication terminal according to the fifth embodiment of this application. As shown in FIG. 14, the in-vehicle communication terminal includes a terminal housing 800, a printed circuit board module 500, a thermally conductive medium 700, and a heat exchange module 100. The in-vehicle communication terminal may be disposed on an inner side of a metal housing of a vehicle, for example, the inner side of the roof housing 910. In this way, the roof housing 910 is equivalent to the uniform temperature metal plate 200 in any one of the foregoing embodiments. An opening 810 is disposed on the terminal housing 800, and the opening 810 faces the roof housing 910. The heat exchange module 100 is disposed in the opening 810, the heat exchange module 100 includes a cold side and a hot side, the cold side faces the terminal housing 800, the hot side faces the roof housing 910, a temperature of the cold side is lower than a temperature of the hot side, and the heat exchange module 100 is configured to conduct heat from the cold side to the hot side. The printed circuit board module 500 is disposed in the terminal housing 800, the printed circuit board module 500 includes a printed circuit board 510, and an antenna 520 and a crystal module 530 that are mounted on the printed circuit board, and the printed circuit board module 510 is attached to the cold side. The thermally conductive medium 700 is disposed between the heat exchange module 100 and the roof housing 910, and the hot side and the roof housing 910 are attached and connected through the thermally conductive medium 700, to form a heat transfer channel from the printed circuit board module 500 to the roof housing 910. That the printed circuit board module 500 is attached to the cold side of the heat exchange module 100 may specifically include: The crystal module 530 is attached to the cold side of the heat exchange module 100 (for example, the second embodiment), or the printed circuit board 510 is connected to the cold side of the heat exchange module 100 (for example, the third embodiment).

Usually, the roof housing 910 is usually made of a metal material, for example, a steel plate, has good thermal conductivity, and has a large area. Therefore, the uniform temperature metal plate 200 taken from the roof housing 910 has good heat dissipation performance because of a large heat dissipation area. In this case, no additional heat sink needs to be configured for the uniform temperature metal plate 200 (namely, the roof housing 910). This is conducive to simplifying a structure of the in-vehicle communication terminal and reducing a volume of the in-vehicle communication terminal. In addition, because of having good conductivity, the roof housing 910 made of a metal material may be further electrically coupled to the printed circuit board module 500, to be used as an antenna of the in-vehicle communication terminal, thereby further simplifying the structure of the in-vehicle communication terminal and reducing the volume of the in-vehicle communication terminal.

The following specifically describes, with reference to FIG. 14, a beneficial effect that can be implemented by the in-vehicle communication terminal according to the fifth embodiment of this application. In the in-vehicle communication terminal provided in the fifth embodiment of this application, the heat transfer channel from the printed circuit board module 500 to the roof housing 910 is established, a temperature of the crystal module 530 is reduced to be lower than an ambient temperature by using the heat exchange module 100, heat generated by the crystal module 530 is transferred to the roof housing 910, and the heat is rapidly dissipated to an environment by using the large heat dissipation area of the roof housing 910. Therefore, even if the roof housing 910 is exposed to sunlight and has an extremely high temperature, the temperature of the crystal module 530 does not approach a threshold temperature when being cooled by the heat exchange module 100, so that it is ensured that the crystal module 530 continuously stably operates without frequency reduction, self-protection, and damage. In addition, the terminal housing, the printed circuit board module 500, the thermally conductive medium 700, and the heat exchange module 100 that are of the in-vehicle communication terminal provided in the fifth embodiment of this application are all disposed in an interlayer space between the roof housing 910 and the top of an interior decoration 920 without additionally occupying a vehicle body space and increasing a roof thickness. In addition, the in-vehicle communication terminal provided in the fifth embodiment of this application has no fan, so that noise is not generated; and there is no need to add an air duct to the roof, so that an appearance of the entire vehicle is not affected.

An embodiment of this application further provides a vehicle. The vehicle may be an automobile, a railway vehicle, an engineering vehicle, or the like. The automobile may be, for example, a minibus, a medium bus, a bus, a van, or a special vehicle (for example, a fire fighting truck, an ambulance, or a police car). The railway vehicle may be, for example, a passenger train, a freight train, a magnetic levitation train, or a subway train. The engineering vehicle may be, for example, a loader, an excavator, a harvester, or a road roller. The vehicle may include one or more of the heat dissipation apparatus, the in-vehicle antenna module, or the in-vehicle communication terminal provided in any one of the foregoing embodiments of this application.

For example, as shown in FIG. 12, the vehicle includes the in-vehicle antenna module 930. The chamber 940 configured to accommodate the in-vehicle antenna module 930 is disposed on the roof housing 910 of the vehicle, and the in-vehicle antenna module 930 is disposed in the chamber 940. The antenna cover 950 is further disposed on the roof housing 910, and the antenna cover 950 is buckled on the chamber 940 to enclose the chamber 940, so that the in-vehicle antenna module 930 is hidden inside the roof housing 910, thereby preventing a roof appearance from being affected.

For example, as shown in FIG. 13, the vehicle includes the in-vehicle communication terminal 960. The in-vehicle communication terminal 960 is hidden on the inner side of the roof housing 910 of the vehicle, the in-vehicle communication terminal 960 is connected to the external antenna 970 of the vehicle through a cable or the like, and the external antenna may be a shark fin antenna at the rear part of the roof. A communication connection is established between the in-vehicle communication terminal 960 and the mobile device 980 through the external antenna 970, to display and control the vehicle information of the mobile device APP.

The following is a sixth embodiment of this application.

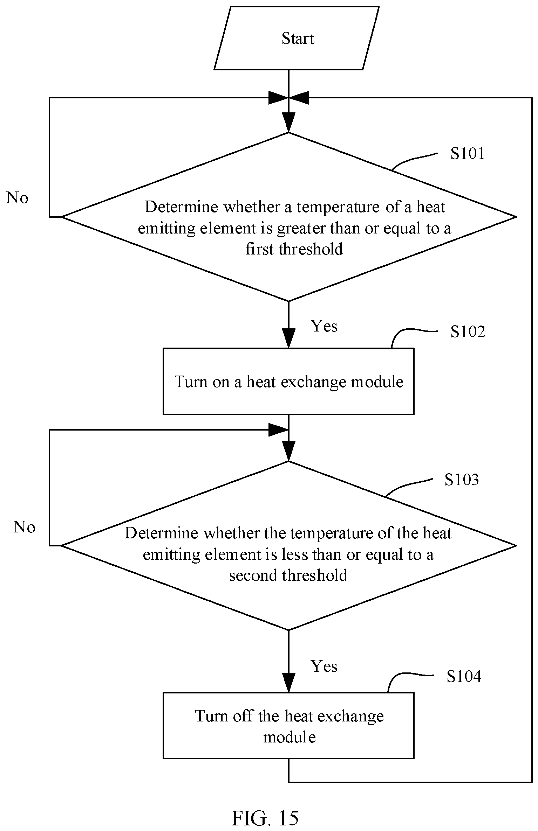

The sixth embodiment of this application provides a temperature control method. The temperature control method may be applied to the heat dissipation apparatus, the in-vehicle antenna module, or the in-vehicle communication terminal provided in any one of the foregoing embodiments. FIG. 15 is a flowchart of the temperature control method. As shown in FIG. 15, the temperature control method includes the following steps:
Step S101: Determine whether a temperature of a heat emitting element is greater than or equal to a first threshold.

The heat emitting element in this application includes but is not limited to a printed circuit board (printed circuit board, PCB), a crystal module (including various chips such as a system-on-a-chip (system on a chip, SOC), a front-end radio frequency chip, and a modem chip), and another electronic element that can generate heat during operation.

The first threshold is less than a threshold temperature of the heat emitting element. For example, when the heat emitting element is a crystal module, the first threshold may be lower than the threshold temperature, so that the crystal module does not have an overheated temperature resulting in frequency reduction. A temperature of the heat emitting element may be measured by using a built-in temperature sensor of the heat emitting element, or may be measured by using another external sensor.

Step S102: Turn on a heat exchange module if the temperature of the heat emitting element is greater than or equal to the first threshold.

If the temperature of the heat emitting element is greater than or equal to the first threshold, it indicates that the temperature of the heat emitting element is high and may be further increased. If the temperature of the heat emitting element is further increased, frequency reduction caused by overheating occurs on the heat emitting element, or even the heat emitting element is damaged because the temperature of the heat emitting element is higher than the threshold temperature. Therefore, the heat exchange module needs to be turned on to cool the heat emitting element.

Step S103: Determine whether the temperature of the heat emitting element is less than or equal to a second threshold.

The second threshold may be equal to or lower than the first threshold.

Step S104: Turn off the heat exchange module if the temperature of the heat emitting element is less than or equal to the second threshold.

When the temperature of the heat emitting element is less than or equal to the first threshold, it indicates that the temperature of the heat emitting element is reduced to be within a normal temperature range, and the heat emitting element can normally operate. Therefore, the heat exchange module can be turned off to reduce power consumption of the heat exchange module. After this, if the temperature of the heat emitting element increases but is less than the first threshold, the heat exchange module keeps in an off state. If the temperature of the heat emitting element is greater than or equal to the first threshold, the heat exchange module is turned on again.

According to the method provided in the sixth embodiment of this application, the temperature of the heat emitting element can be controlled between the first threshold and the second threshold that are lower than the threshold temperature, and normal operation of the heat emitting element can be ensured. In addition, according to the method provided in the sixth embodiment of this application, the heat exchange module is controlled to be intermittently turned on and off based on the temperature of the heat emitting element. This is further conducive to reducing the power consumption of the heat exchange module. In this case, if the heat exchange module is powered by an in-vehicle storage battery, a battery life of the storage battery in a non-charging state can be prolonged.

The heat dissipation apparatus provided in embodiments of this application may be used in various scenarios in which a device or component has a heat dissipation requirement when operating in a high-temperature environment, for example, an in-vehicle antenna, an outdoor communication base station, a communication satellite, and a computer chip. For application of the technical solutions provided in embodiments of this application to other designs, details are not specifically described herein again. Under inspiration of the technical conceptions of embodiments of this application, a person skilled in the art can further imagine that the technical solutions in embodiments of this application are applied to other designs, and none of these designs exceeds the protection scope of embodiments of this application.

A person skilled in the art can easily figure out another implementation solution of this application after considering the specification and practicing this application that is disclosed herein. This application is intended to cover any variations, functions, or adaptive changes of this application. These variations, functions, or adaptive changes comply with general principles of this application, and include common knowledge or a commonly used technical means in the technical field that is not disclosed in this application. The specification and the embodiments are merely considered as examples, and the actual scope of this application are pointed out by the following claims.

It should be understood that this application is not limited to the accurate structures that are described in the foregoing and that are shown in the accompanying drawings, and modifications and changes may be made without departing from the scope of this application. The scope of this application is limited only by the appended claims.

## Claims

1. An in-vehicle antenna module, comprising:
an antenna housing (600), a printed circuit board module (500), a heat exchange module (100), a uniform temperature metal plate (200), and a heat sink (300), wherein
the heat exchange module (100) comprises a cold side and a hot side, a temperature of the cold side is lower than a temperature of the hot side, and the heat exchange module (100) is configured to conduct heat from the cold side to the hot side;
the printed circuit board module (500) comprises a printed circuit board (510), and an antenna (520) and a crystal module (530) that are mounted on the printed circuit board, the printed circuit board module (500) is attached to the cold side, and the uniform temperature metal plate (200) is attached to the hot side;
the heat sink (300) is attached to one side that is of the uniform temperature metal plate (200) and that faces away from the heat exchange module (100); and **characterized in that**
the antenna housing (600) is disposed on one side that is of the uniform temperature metal plate (200) and that faces the heat exchange module (100), fastening structures that cooperate with each other are respectively disposed on the uniform temperature metal plate (200) and the antenna housing (600), and the uniform temperature metal plate (200) and the antenna housing (600) are fixedly connected through the fastening structures, to enclose the printed circuit board module (500) and the heat exchange module (100) in the antenna housing (600).

2. The in-vehicle antenna module according to claim 1, wherein
the crystal module (530) is disposed on one side that is of the printed circuit board (510) and that faces the heat exchange module (100); and
the crystal module (530) is attached to the cold side.

3. The in-vehicle antenna module according to claim 1, wherein
the printed circuit board (510) is attached to the cold side; and
the crystal module (530) is disposed on one side that is of the printed circuit board (510) and that faces away from the heat exchange module (100).

4. The in-vehicle antenna module according to claim 1, wherein
the uniform temperature metal plate (200) is recessed in a direction away from the heat exchange module (100), to form a first groove (210);
the heat exchange module (100) is disposed in the first groove (210), and the hot side is attached to a bottom of the first groove (210);
the heat sink (300) is recessed in a direction away from the uniform temperature metal plate (200), to form a second groove (320) that matches the first groove (210) in shape; and
the first groove (210) is embedded into the second groove, and the first groove (210) is tightly attached to the second groove.

5. The in-vehicle antenna module according to claim 2, wherein a thermally conductive medium is disposed between the heat exchange module (100) and the crystal module (530), and the cold side is attached to the crystal module (530) through the thermally conductive medium.

6. The in-vehicle antenna module according to claim 1, wherein the antenna (520) is disposed on one side that is of the printed circuit board (510) and that faces away from the heat exchange module (100).

7. The in-vehicle antenna module according to any one of claims 1 to 6, wherein the heat exchange module (100) is a thermoelectric cooler.

8. The in-vehicle antenna module according to claim 7, wherein
the thermoelectric cooler comprises a plurality of thermocouple pairs, and each thermocouple pair is formed by connecting an N-type semiconductor and a P-type semiconductor;
the plurality of thermocouple pairs are arranged between two ceramic electrodes; and
the thermocouple pairs are configured to transfer heat from the cold side to the hot side when a current passes through.

9. The in-vehicle antenna module according to claim 1, wherein
a fin structure (310) is disposed on one side that is of the heat sink (300) and that faces away from the uniform temperature metal plate (200);
the fin structure (310) comprises a plurality of fins, and the fins extend in a direction away from the uniform temperature metal plate (200); and
the plurality of fins are spaced from each other in parallel.

10. A vehicle, comprising:
the in-vehicle antenna module according to any one of claims 1 to 9, wherein
a chamber configured to accommodate the in-vehicle antenna module is disposed on a roof housing of the vehicle;
the in-vehicle antenna module is disposed in the chamber; and
an antenna cover is further disposed on the roof housing, and the antenna cover is buckled on the chamber to enclose the chamber.

## Patentansprüche

1. Fahrzeuginternes Antennenmodul, umfassend:
ein Antennengehäuse (600), ein Leiterplattenmodul (500), ein Wärmetauschmodul (100), eine Metallplatte mit gleichmäßiger Temperatur (200) und einen Kühlkörper (300), wobei
das Wärmetauschmodul (100) eine kalte Seite und eine warme Seite umfasst, wobei eine Temperatur der kalten Seite niedriger ist als eine Temperatur der warmen Seite und das Wärmetauschmodul (100) konfiguriert ist, um Wärme von der kalten Seite zu der warmen Seite zu leiten;
das Leiterplattenmodul (500) eine Leiterplatte (510) und eine Antenne (520) und ein Kristallmodul (530) umfasst, die auf der Leiterplatte montiert sind, das Leiterplattenmodul (500) an der kalten Seite angebracht ist und die Metallplatte mit gleichmäßiger Temperatur (200) an der warmen Seite angebracht ist;
der Kühlkörper (300) an einer Seite angebracht ist, die von der Metallplatte mit gleichmäßiger Temperatur (200) ist und die von dem Wärmetauschmodul (100) abgewandt ist; und **dadurch gekennzeichnet, dass**
das Antennengehäuse (600) an einer Seite angeordnet ist, die von der Metallplatte mit gleichmäßiger Temperatur (200) ist und die dem Wärmetauschmodul (100) zugewandt ist, Befestigungskonstruktionen, die miteinander zusammenwirken, jeweils auf der Metallplatte mit gleichmäßiger Temperatur (200) und dem Antennengehäuse (600) angeordnet sind und die Metallplatte mit gleichmäßiger Temperatur (200) und das Antennengehäuse (600) durch die Befestigungskonstruktionen fest miteinander verbunden sind, um das Leiterplattenmodul (500) und das Wärmetauschmodul (100) in dem Antennengehäuse (600) zu umschließen.

2. Fahrzeuginternes Antennenmodul nach Anspruch 1, wobei
das Kristallmodul (530) an einer Seite angeordnet ist, die von der Leiterplatte (510) ist und die dem Wärmetauschmodul (100) zugewandt ist; und
das Kristallmodul (530) an der kalten Seite angebracht ist.

3. Fahrzeuginternes Antennenmodul nach Anspruch 1, wobei
die Leiterplatte (510) an der kalten Seite angebracht ist; und
das Kristallmodul (530) an einer Seite angeordnet ist, die von der Leiterplatte (510) ist und die von dem Wärmetauschmodul (100) abgewandt ist.

4. Fahrzeuginternes Antennenmodul nach Anspruch 1, wobei
die Metallplatte mit gleichmäßiger Temperatur (200) in einer Richtung weg von dem Wärmetauschmodul (100) vertieft ist, um eine erste Nut (210) zu bilden;
das Wärmetauschmodul (100) in der ersten Nut (210) angeordnet ist und die warme Seite an einem Boden der ersten Nut (210) angebracht ist;
der Kühlkörper (300) in einer Richtung weg von der Metallplatte mit gleichmäßiger Temperatur (200) vertieft ist, um eine zweite Nut (320) zu bilden, die in einem Verlauf zu der ersten Nut (210) passt; und
die erste Nut (210) in die zweite Nut eingebettet ist und die erste Nut (210) dicht an der zweiten Nut angebracht ist.

5. Fahrzeuginternes Antennenmodul nach Anspruch 2, wobei ein wärmeleitendes Medium zwischen dem Wärmetauschmodul (100) und dem Kristallmodul (530) angeordnet ist und die kalte Seite über das wärmeleitende Medium an dem Kristallmodul (530) angebracht ist.

6. Fahrzeuginternes Antennenmodul nach Anspruch 1, wobei die Antenne (520) an einer Seite angeordnet ist, die von der Leiterplatte (510) ist und die von dem Wärmetauschmodul (100) abgewandt ist.

7. Fahrzeuginternes Antennenmodul nach einem der Ansprüche 1 bis 6, wobei das Wärmetauschmodul (100) ein thermoelektrischer Kühler ist.

8. Fahrzeuginternes Antennenmodul nach Anspruch 7, wobei
der thermoelektrische Kühler eine Vielzahl von Thermoelementpaaren umfasst, wobei jedes Thermoelementpaar durch Verbinden eines N-Typ-Halbleiters und eines P-Typ-Halbleiters gebildet ist;
die Vielzahl von Thermoelementpaaren zwischen zwei Keramikelektroden angeordnet ist; und
die Thermoelementpaare konfiguriert sind, um Wärme von der kalten Seite auf die warme Seite zu übertragen, wenn ein Strom hindurchpassiert.

9. Fahrzeuginternes Antennenmodul nach Anspruch 1, wobei
eine Rippenstruktur (310) an einer Seite angeordnet ist, die von dem Kühlkörper (300) ist und die von der Metallplatte mit gleichmäßiger Temperatur (200) abgewandt ist;
die Rippenstruktur (310) eine Vielzahl von Rippen umfasst und sich die Rippen in einer Richtung weg von der Metallplatte mit gleichmäßiger Temperatur (200) erstrecken; und
die Vielzahl von Rippen parallel zueinander beabstandet sind.

10. Fahrzeug, umfassend:
das fahrzeuginterne Antennenmodul nach einem der Ansprüche 1 bis 9, wobei
eine Kammer, die konfiguriert ist, um das fahrzeuginterne Antennenmodul unterzubringen, auf einem Dachgehäuse des Fahrzeugs angeordnet ist;
das fahrzeuginterne Antennenmodul in der Kammer angeordnet ist; und
eine Antennenabdeckung ferner auf dem Dachgehäuse angeordnet ist und die Antennenabdeckung auf die Kammer geschnallt ist, um die Kammer zu umschließen.

## Revendications

1. Module d'antenne monté sur véhicule, comprenant :
un boîtier d'antenne (600), un module de carte de circuit imprimé (500), un module d'échange de chaleur (100), une plaque métallique à température uniforme (200) et un dissipateur de chaleur (300), dans lequel
le module d'échange de chaleur (100) comprend un côté froid et un côté chaud, une température du côté froid est inférieure à une température du côté chaud, et le module d'échange de chaleur (100) est configuré pour conduire la chaleur du côté froid vers le côté chaud ;
le module de carte de circuit imprimé (500) comprend une carte de circuit imprimé (510), et une antenne (520) et un module à cristaux (530) qui sont montés sur la carte de circuit imprimé, le module de carte de circuit imprimé (500) est fixé au côté froid et la plaque métallique à température uniforme (200) est fixée au côté chaud ;
le dissipateur de chaleur (300) est fixé à un côté de la plaque métallique à température uniforme (200) et qui est orienté dans la direction opposée au module d'échange de chaleur (100) ; et
**caractérisé en ce que**
le boîtier d'antenne (600) est disposé d'un côté de la plaque métallique à température uniforme (200) et qui fait face au module d'échange de chaleur (100), des structures de fixation qui coopèrent entre elles sont respectivement disposées sur la plaque métallique à température uniforme (200) et le boîtier d'antenne (600), et la plaque métallique à température uniforme (200) et le boîtier d'antenne (600) sont fixés par les structures de fixation, afin d'enfermer le module de carte de circuit imprimé (500) et le module d'échange de chaleur (100) dans le boîtier d'antenne (600).

2. Module d'antenne monté sur véhicule selon la revendication 1, dans lequel
le module à cristaux (530) est disposé sur un côté de la carte de circuit imprimé (510) et qui fait face au module d'échange de chaleur (100) ; et
le module à cristaux (530) est fixé au côté froid.

3. Module d'antenne monté sur véhicule selon la revendication 1, dans lequel
la carte de circuit imprimé (510) est fixée au côté froid ; et
le module à cristaux (530) est disposé sur un côté de la carte de circuit imprimé (510) et qui est orienté dans la direction opposée au module d'échange de chaleur (100).

4. Module d'antenne monté sur véhicule selon la revendication 1, dans lequel
la plaque métallique à température uniforme (200) est encastrée dans une direction opposée au module d'échange de chaleur (100), afin de former une première rainure (210) ;
le module d'échange de chaleur (100) est disposé dans la première rainure (210), et le côté chaud est fixé au fond de la première rainure (210) ;
le dissipateur de chaleur (300) est encastré dans une direction opposée à la plaque métallique à température uniforme (200), afin de former une seconde rainure (320) dont la forme correspond à celle de la première rainure (210) ; et
la première rainure (210) est intégrée dans la seconde rainure, et la première rainure (210) est étroitement fixée à la seconde rainure.

5. Module d'antenne monté sur véhicule selon la revendication 2, dans lequel un milieu thermoconducteur est disposé entre le module d'échange de chaleur (100) et le module à cristaux (530), et le côté froid est fixé au module à cristaux (530) par l'intermédiaire du milieu thermoconducteur.

6. Module d'antenne monté sur véhicule selon la revendication 1, dans lequel l'antenne (520) est disposé sur un côté de la carte de circuit imprimé (510) et qui est orienté dans la direction opposée au module d'échange de chaleur (100).

7. Module d'antenne monté sur véhicule selon l'une quelconque des revendications 1 à 6, dans lequel le module d'échange de chaleur (100) est un refroidisseur thermoélectrique.

8. Module d'antenne monté sur véhicule selon la revendication 7, dans lequel
le refroidisseur thermoélectrique comprend une pluralité de paires de thermocouples, et chaque paire de thermocouples est formée en connectant un semi-conducteur de type N et un semi-conducteur de type P ;
la pluralité de paires de thermocouples sont agencées entre deux électrodes en céramique ; et
les paires de thermocouples sont configurées pour transférer la chaleur du côté froid vers le côté chaud lorsqu'un courant les traverse.

9. Module d'antenne monté sur véhicule selon la revendication 1, dans lequel
une structure à ailettes (310) est disposée sur un côté du dissipateur de chaleur (300) et qui est orienté dans la direction opposée à la plaque métallique à température uniforme (200) ;
la structure à ailettes (310) comprend une pluralité d'ailettes, et les ailettes se prolongent dans une direction opposée à la plaque métallique à température uniforme (200) ; et
la pluralité d'ailettes sont espacées parallèlement les unes des autres.

10. Véhicule, comprenant :
le module d'antenne monté sur véhicule selon l'une quelconque des revendications 1 à 9, dans lequel
une chambre configurée pour accueillir le module d'antenne monté sur véhicule est disposée sur un toit du véhicule ;
le module d'antenne monté sur véhicule est disposé dans la chambre ; et
un couvercle d'antenne est également disposé sur le boîtier du toit, et le couvercle d'antenne est attaché sur la chambre pour fermer la chambre.
